(19) Europäisches Patentamt
European Patent Office
Office européen des brevets

(11) Veröffentlichungsnummer: **0 212 263 B1**

# (12) EUROPÄISCHE PATENTSCHRIFT

(45) Veröffentlichungstag der Patentschrift: **17.04.91**

(51) Int. Cl.[5]: **G03F 7/32**

(21) Anmeldenummer: **86109804.4**

(22) Anmeldetag: **17.07.86**

## (54) Entwicklergemisch zum Entwickeln von Flachdruckplatten.

(30) Priorität: **05.08.85 US 762602**

(43) Veröffentlichungstag der Anmeldung:
**04.03.87 Patentblatt 87/10**

(45) Bekanntmachung des Hinweises auf die Patenterteilung:
**17.04.91 Patentblatt 91/16**

(84) Benannte Vertragsstaaten:
**DE FR GB NL**

(56) Entgegenhaltungen:
**EP-A- 0 051 081**
**DE-A- 2 924 294**
**GB-A- 1 492 620**
**US-A- 4 391 897**

**PATENT ABSTRACTS OF JAPAN, Band 5, Nr. 5 (P-44)[677], 14. Januar 1981; & JP-A-55 137 524 (DAICEL K.K.) 27-10-1980**

**PATENT ABSTRACTS OF JAPAN, Band 5, Nr. 5 (P-44)[677], 14. Januar 1981; & JP-A-55 137 527 (DAICEL K.K.) 27-10-1980**

(73) Patentinhaber: **HOECHST CELANESE CORPORATION**
**Route 202-206 North**
**Somerville, N.J. 08876(US)**

(72) Erfinder: **Hsieh, Shane**
**4, Linvale Lane**
**Bridgewater New Jersey 08807(US)**
Erfinder: **Mitchell, Wayne A.**
**8, Shydy Lane**
**Bound Brook New Jersey 08805(US)**

(74) Vertreter: **Euler, Kurt Emil, Dr. et al**
**KALLE Niederlassung der Hoechst AG**
**Rheingaustrasse 190 Postfach 3540**
**W-6200 Wiesbaden 1(DE)**

**EP 0 212 263 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein Entwicklergemisch zum Entfernen der Nichtbildstellen von belichteten Flachdruckplatten, die aus einem mit einer lichtempfindlichen Schicht versehenen Schichtträger bestehen.

Es wurden in der Vergangenheit verschiedene Verfahren zum Entwickeln von Druckplatten eingesetzt. Z.B. wurden Gemische verwendet, die aus Lösungen von organischen Lösemitteln, Netzmitteln, Salzen, Säuren und anderen aus dem Stand der Technik bekannten Stoffen bestehen.

Es wird angestrebt, ein Entwicklergemisch herzustellen, mit dem die Entwicklung innerhalb kurzer Zeit erfolgen kann. Die oleophilen Bildstellen der Druckplatte sollten dabei farbannehmend und wasserabstoßend sein, während die hydrophilen Nichtbildstellen Wasser annehmen und fette Druckfarbe abstoßen sollten.

Die richtige Auswahl der für die Entwicklerlösung jeweils verwendeten organischen Lösemittel ist von großer Bedeutung. Wenn das eingesetzte Lösemittel für das lichtempfindliche Gemisch selbst gut geeignet ist, findet keine genügende Unterscheidung zwischen den belichteten und den unbelichteten Stellen statt. Infolgedessen wird ein Großteil der Schichtbestandteile der Bildstellen im Lösemittel gelöst oder quillt stark an und löst sich ab. Solche Druckplatten sind unbrauchbar. Durch die Zugabe von Wasser zur Senkung der Lösemittelkonzentration in der Entwicklerlösung kann die Bilddifferenzierung verbessert werden. Während der Entwicklung von Druckplatten, insbesondere von negativ arbeitenden Druckplatten, werden jedoch die an den Nichtbildstellen vorhandenen harzartigen Bindemittel, wie Acetale, insbesondere Polyvinylformal, in der Entwicklerlösung solvatisiert und lösen sich vom Schichtträger ab und ballen sich zu kugeligen, sehr klebrigen Gebilden zusammen. Derartige solvatisierte Partikel lagern sich auf den noch lösemittelfeuchten Bildstellen ab und bleiben dort auch nach dem Trocknen haften. Diese "wiederangelagerten" Stellen sind mit bloßem Auge auf der entwickelten Druckplatte erkennbar und werden überdies von der klebrigen Druckfarbe beim Druckvorgang zusammen mit der eigentlichen, darunterliegenden Bildstelle von der Platte abgerissen, wodurch Löcher entstehen, die auf dem fertigen Druck als bildfreie Stellen erkennbar sind.

Um diesem Problem wenigstens teilweise abzuhelfen, werden in vielen bekannten Entwicklergemischen flüchtige Lösemittel verwendet. Von der Anwesenheit solch flüchtiger Lösemittel in der Entwicklerlösung erhofft man sich, daß durch eine rasche Verdampfung des Lösemittels das Klebrigwerden der Bildstellen verhindert wird. Die Verwendung großer Mengen wasserlöslicher Lösemittel mit niedrigem Siedepunkt, wie sie z.B. im Entwickler gemäß der US-A 3 954 472 vorgeschlagen wurden, führt jedoch zu Problemen im Hinblick auf eine Gesundheitsgefährdung am Arbeitsplatz, Sicherheitsrisiken aufgrund des niedrigen Flammpunktes und Umweltbelastungen. Durch eine Senkung der Konzentration dieser wasserlöslichen Lösemittel mit niedrigem Siedepunkt können diese Probleme zwar auf ein Minimum reduziert werden, doch verlängert sich gleichzeitig die Entwicklungszeit. Die Klebrigkeit der Schichten wird zwar verringert, kann aber nicht völlig ausgeschaltet werden.

Um die für die Entwicklung benötigte Zeit bei der Verwendung von Entwicklerlösungen mit einem geringeren Gehalt an niedrigsiedenden Lösemitteln abzukürzen, wird in einigen Fällen zusätzlich ein organisches Lösemittel eingesetzt. Derartige Entwickler weisen jedoch auch etliche Nachteile auf, wie z.B. Toxitizät, geringere Entwicklerstabilität, Geruchsbelästigung oder Unvermögen, den Bildhintergrund an den Nichtbildstellen vollständig freizulegen.

Flachdruckplatten bestehen im allgemeinen aus einem Schichtträger auf Aluminiumbasis, der gegebenenfalls mit Hilfe eines der vielen bekannten Verfahren vorbehandelt wurde, z.B. durch anodische Oxidation, verschiedene Aufrauhverfahren oder Hydrophilierung. Auf den solchermaßen vorbereiteten Schichtträger wird eine lichttempfindliche Schicht aus lichtempfindlicher Verbindung, harzartigen Bindemitteln, Farbmitteln, stabilisierenden Säuren, Netzmitteln und anderen bekannten Bestandteilen aufgetragen. Zu den üblicherweise verwendeten lichtempfindlichen Verbindungen zählen Diazoniumverbindungen, wie polymere Diazoniumsalzkondensationsprodukte, Chinondiazide und photopolymerisierbare Gemische. Lichtempfindliche Verbindungen, Bindemittel und Druckplatten, für deren Herstellung aromatische Diazoniumverbindungen verwendet werden, sind beispielsweise aus den US-A 3 175 906, 3 046 118, 2 063 631, 2 667 415, 3 867 147 und 3 679 419 bekannt.

Typische, zum Stand der Technik zählende Entwicklergemische sind in den US-A 2 754 279 und 4 381 340 sowie in der DE-A 22 16 419 beschrieben.

Um mit den jeweils verwendeten Druckplatten die bestmögliche Druckleistung erzielen zu können, ist es heute üblich, ein auf jeden einzelnen Druckplattentyp, d.h. auf das dem lichtempfindlichen Gemisch jeweils zugesetzte Bindemittel, genau abgestimmtes Entwicklergemisch zu verwenden. Es ist sogar üblich, unterschiedliche Entwickler zu verwenden für Druckplatten, in deren lichtempfindlicher Schicht das gleiche Bindemittel enthalten ist und die sich lediglich dadurch voneinander unterscheiden, daß die Schichtträger mechanisch, bzw. elektrolytisch aufgerauht wurden.

Aufgabe der vorliegenden Erfindung ist es, die erwähnten Nachteile der bekannten Entwickler für Flachdruckplatten zu überwinden, wobei ein Verfahren zum Entwickeln verschiedener Druckplattentypen vorgesehen ist, das nur mit einem einzigen Entwicklergemisch arbeitet. Es sollen sowohl Druckplatten mit Schichtträgern aus mechanisch aufgerauhtem Aluminium, als auch Druckplatten mit Schichtträgern aus elektrolytisch aufgerauhtem Aluminium ohne wesentliche Unterschiede in der Entwicklungszeit entwickelt werden können.

Aufgabe der vorliegenden Erfindung ist es weiterhin, einen Entwickler für Flachdruckplatten zu schaffen, mit dessen Hilfe die Herstellung von Druckplatten möglich wird, die im wesentlichen frei sind von unerwünschten Wiederanlagerungen. Das Entwicklergemisch soll außerdem keine Schaumbildung und weniger Geruchsbelästigungen durch Lösungsmittel verursachen und ferner einen höheren Flammpunkt besitzen. Unter dem Aspekt der Wirtschaftlichkeit betrachtet, soll gleichzeitig eine rasche und leichte Entfernung der Nichtbildstellen erreicht werden und der Entwickler eine besonders lange Gebrauchsdauer besitzen. Die Wirkungsweise des Entwicklers soll insgesamt sehr ausgeglichen sein. Er soll weder zu aggressiv sein, noch sollen lange Entwicklungszeiten erforderlich sein, während er gleichzeitig für die Entwicklung zahlreicher verschiedener Druckplatten, in denen unterschiedliche lichtempfindliche Gemische enthalten sind, geeignet sein soll.

Die Erfindung betrifft ein wäßriges Entwicklergemisch zum Entfernen der Nichtbildstellen einer auf einem Träger befindlichen lichtempfindlichen Substanz nach deren Belichtung, wobei das Entwicklergemisch organische Lösemittel und Salze enthält, dessen kennzeichnendes Merkmal darin besteht, daß es

a) 5 bis 30 Gew.-% Benzylalkohol,

b) 1 bis 20 Gew.-% eines Alkali-, bevorzugt Natrium-, -xylolsulfonates und/oder Alkali-, bevorzugt Natrium-, -cumolsulfonates,

c) 5 bis 40 Gew.-% eines Alkali-, bevorzugt Kalium-, -toluolsulfonates, und

d) ergänzt zu 100 Gew.-% Wasser

enthält.

Gegebenenfalls kann der Entwickler außerdem Salze,Antioxidantien und ein anionisches oder nichtionisches Netzmittel enthalten.

Bei der Herstellung lichtempfindlicher Materialien, wie z. B. Flachdruckplatten, wird zunächst ein blattförmiger Träger, der beispielsweise aus zur Herstellung von Flachdruckplatten geeigneten Aluminiumlegierungen wie Alcoa 3003 der Alcoa 1100 besteht und gegebenenfalls auf übliche Weise, z.B. durch mechanisches oder elektrolytisches Aufrauhen und/oder Ätzen und/oder anodische Oxidation vorbehandelt und gegebenenfalls außerdem mit einem Gemisch, wie z.B. Polyvinylphosphonsäure, behandelt wurde, das als Hydrophilierungsmittel für Flachdruckplatten geeignet ist, mit einem lichtempfindlichen, ein polymeres Diazoniumsalz, ein Chinondiazid oder ein ein Photopolymeres enthaltenden Gemisch beschichtet. Dieses Gemisch kann außerdem harzförmige Bindemittel wie Polyvinylacetat-oder Polyvinylformalharze, Novolake, Polyurethane, Polyvinylacetate oder Styrol-Maleinsäureanhydrid-Copolymere, Farbmittel, stabilisierende Säuren, Netzmittel, Belichtungsindikatoren oder andere bekannte Zusätze enthalten.

Anschließend wird das lichtempfindliche blattförmige Material mittels einer Strahlungsquelle durch eine Maske oder Transparentvorlage belichtet und die belichtete Platte zur Entfernung der Nichtbildstellen entwickelt.

Das lichtempfindliche Gemisch wird gewöhnlich als Gemisch in einem Lösemittelsystem hergestellt, das mit allen übrigen Bestandteilen verträglich ist. Der Schichtträger wird mit diesem lichtempfindlichen Gemisch beschichtet, und das Lösemittel wird verdampft.

Die Diazoniumverbindungen, die im Rahmen dieser Erfindung für die Herstellung lichtempfindlicher Gemische am häufigsten verwendet werden, entsprechen der allgemeinen Formel $A\text{-}N_2^+X^-$, in der A ein aromatischer oder heterozyklischer Rest und X das Anion einer Säure ist.

Zu den für die vorstehend genannten Zwecke geeigneten lichtempfindlichen Diazoniummaterialien gehören insbesondere höhermolekulare Gemische, die z. B. durch die Kondensation bestimmter aromatischer Diazoniumsalze in einem sauren Medium mit bestimmten aromatischen Carbonylverbindungen wie Formaldehyd erhalten werden, wie es beispielsweise in den US-A 2 063 631 und 2 667 415 beschrieben ist. Eine Gruppe bevorzugt eingesetzter Diazoniumverbindungen, ist in der US-A 3 849 392 beschrieben. Besonders bevorzugt wird unter den Diazoniumsalzen das aus der US-A 3 849 392 bekannte, als Mesitylensulfonat ausgefällte Polykondensationsprodukt aus 3-Methoxy-4-diazodiphenylaminsulfat und 4,4'-Bismethoxymethyldiphenylether.

Geeignete photopolymerisierbare Gemische sind dem Fachmann bekannt.

Die vorliegende Erfindung sieht ein Verfahren zum Entwickeln derartiger belichteter, lichtempfindlicher Materialien vor, in dem zum Entfernen der Nichtbildstellen ein Entwickler verwendet wird, der die erwähnten Bestand. teile in wäßriger Lösung enthält. Der erfindungsgemäß erhaltene Entwickler hat bevorzugt einen

Flammpunkt von über mindestens 93 °C (200 °F), insbesondere von mindestens 104°C (220 °F).

Die Alkali-, bevorzugt Kalium-, -toluolsulfonatkomponente ist in dem wäßrigen Gemisch in einer Menge von 5 bis 40 Gew.-%, insbesondere von 15 bis 35 Gew.-%, und bevorzugt von 20 bis 30 Gew.-%, jeweils bezogen auf das Gesamtgewicht des Gemisches, enthalten.

Die Alkali-, bevorzugt Natrium-, -xylol- und/oder Alkali-, bevorzugt Natrium-, -cumolsulfonatkomponente ist in dem wäßrigen Gemisch in einer Menge von 1 bis 20 Gew.-%, insbesondere von 3 bis 15 Gew.-%, und bevorzugt von 4 bis 10 Gew.-%, jeweils bezogen auf das Gesamtgewicht des Gemisches, enthalten.

Die Benzylalkoholkomponente ist in dem wäßrigen Gemisch in einer Menge von 5 bis 30 Gew.-%, insbesondere von 8 bis 25 Gew.-%, und bevorzugt von 10 bis 15 Gew.-%, jeweils bezogen auf das Gesamtgewicht des Gemisches, enthalten.

Das Gemisch enthält bevorzugt auch mindestens ein Salz aus der Gruppe der Kalium- und Natriumphosphate, -nitrate, -chloride, -borate, -acetate, -sulfate, -citrate, -sulfite, -tartrate, -oxalate, -formiate, -propionate, -succinate, -glutamate und -benzoate. Die Salzkomponente ist im Entwickler in einer Menge von 0,1 bis 10 Gew.-%, bevorzugt von 0,1 bis 3 Gew.-% und insbesondere von 0,1 bis 1 Gew.-%, jeweils bezogen auf das Gewicht des Entwicklers, vorhanden.

In bevorzugter Ausführungsform kann der erfindungsgemäße Entwickler außerdem geringere Mengen anderer Bestandteile enthalten, die die Verarbeitung der Druckplatte erleichtern. Solche Bestandteile sind beispielsweise Antioxidantien, nicht ionische oder anionische Netzmittel und andere bekannte Substanzen, wie z.B. Mittel zur Verhinderung von Schaumbildung. Antioxidantien werden eingesetzt, um hauptsächlich eine Umwandlung des Benzylalkohols in Benzaldehyd zu verhindern.

Zu den erfindungsgemäß geeigneten Antioxidantien gehören beispielsweise 2,6-Di-tert.-butyl-p-cresol (unter der Bezeichnung Ionol von der Firma Shell Chemical Co., Houston, Texas, erhältlich),Tetra-kis-[methylen(3,5-ditert.-butyl-4-hxdroxy-hydrocinnamat)]-methan (unter der Bezeichnung Irganox 1010 von der Firma Ciba Geigy erhältlich) und 3,4,5-Trihxdroxybenzoesäurepropylester (als Propylgallat von der Firma Alderich Chemical Co., Milwaukee, Wisconsin, erhältlich).

Das gegebenenfalls verwendete Antioxidans wird bevorzugt in einer Menge von 0,005 bis 0,2 Gew.-%, insbesondere von 0,01 bis 0,05 Gew.-%, jeweils bezogen auf das Gesamtgewicht des Gemisches, eingesetzt.

Das Gemisch enthält ferner bevorzugt mindestens ein anionisches oder nichtionisches Netzmittel, das in einer Menge von 0,1 bis 2 Gew.-%, vorzugsweise von 0,5 bis 1 Gew.-%, im Entwicklergemisch enthalten ist, jeweils bezogen auf desssen Gesamtgewicht. Geeignete, bevorzugt eingesetzte Netzmittel entsprechen der allgemeinen Formel

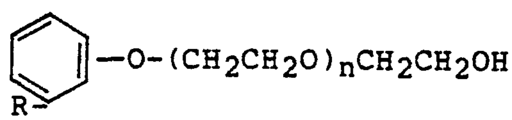

in der

n = 4 - 40 und
R = H
= OH
= $C_8H_{17}$
= $C_9H_{19}$
= $C_{10}H_{21}$ oder
= $CH_3(CH_2)_m$-O-$(CH_2CH_2O)_{n'}CH_2CH_2OH$

bedeuten, wobei

m = 9 - 30
n '= 4 -20 ist.

Zu den devorzugten Netzmilleln zählen:
Nonylphenoxypolyoxyethylenethanol,
Polyoxyethylenmonosorbitanoleat,
Tridecylalkoholpolyoxyethylenethanol,
Isooctylphenoxypolyoxyethylenethanol,
Decylalkoholpolyoxyethylenethanol,
Decylphenoxypolyoxyethylenethanol,
Isooctylphenoxypolyoxyethylenethanol und

Isooctylphenoxyethylenethanol.

Eine ausführliche Beschreibung dieser Netzmittel ist in der US-A4381340 enthalten.

Erfindungsgemäß besonders bevorzugte Netzmittel sind Octylphenoxypolyethoxyethanol (unter der Bezeichnung Triton TX-100 erhältlich von der Firma Rohm & Haas, Philadelphia, Pa.) und Tridecylalkoholpolyoxyethylenethanol (unter der Bezeichnung Trycol OP 407 erhältlich von der Firma Emery Industries, Inc., Cincinnati, Ohio).

Zu den anionischen Netzmitteln gehören u.a. Ammonium-, Kalium- und Natriumlaurysulfat, sowie Natriumtridecylethersulfat. Das Gemisch enthält daneben Wasser in einer zur Herstellung eines wirksamen Entwicklers ausreichenden Menge.

Mit dem erfindungsgemäßen Entwickler ist es möglich, die Nichtbildstellen eines lichtempfindlichen Materials innerhalb von höchstens 2 min praktisch vollständig zu entfernen, ohne daß dabei merkliche Teile der Bildstellen mitentfernt werden. Von dem Material der entfernten Nichtbildstellen wird praktisch nichts auf dem Reproduktionsmaterial wiederangelagert.

Die Erfindung wird anhand der folgenden Beispiele erläutert, ohne jedoch auf diese beschränkt zu sein:

Beispiel 1:

Eine Druckplatte vom Typ Enco N-25$^{(R)}$, deren Aluminiumträgermaterial in einer Schleifmittelsuspension mechanisch aufgerauht wurde, und eine Druckplatte vom Typ Enco N-500$^{(R)}$, deren Aluminiumträgermaterial elektrolytisch aufgerauht wurde, werden in bekannter Weise mittels aktinischer Strahlung bildmäßig belichtet. (Platten dieses Typs sind von der Firma American Hoechst Corp., Somerville, New Jersey, erhältlich.) Ihre lichtempfindliche Schicht enthält ein Polyvinylformalharz und ein Diazoniumsalz, wie in der US-A 3 849 392 beschrieben. Die belichteten Platten werden in einem handelsüblichen Entwicklungsgerät mit dem folgenden Entwicklergemisch entwickelt:

**10,50 Gew.-% Benzylalkohol,**
**29,00 Gew.-% Natriumxylolsulfonat und**
**60,50 Gew.-% Wasser.**

Die Platte vom Typ N-500 kann mit befriedigendem Ergebnis entwickelt werden, während das Bild auf der Platte vom Typ N-25 vom Entwickler vollständig abgewaschen wird.

Beispiel 2:

Eine Druckplatte vom Typ Enco N-25$^{(R)}$, deren Aluminiumträgermaterial in einer Schleifmittelsuspension mechanisch aufgerauht wurde, und eine Druckplatte vom Typ Enco N-500$^{(R)}$, deren Aluminiumträgermaterial elektrolytisch aufgerauht wurde, werden in bekannter Weise mittels aktinischer Strahlung bildmäßig belichtet. Die belichteten Platten werden in einem handelsüblichen Entwicklungsgerät mit dem folgenden Entwicklergemisch entwickelt:

**10,50 Gew.-% Benzylalkohol,**
**29,00 Gew.-% Kaliumtoluolsulfonat und**
**60,50 Gew.-% Wasser.**

Die Platte vom Typ N-25 läßt sich mit befriedigendem Ergebnis entwickeln, während bei der Platte vom Typ N-500 keine einwandfreie Entwicklung möglich ist. Im Rasterbereich werden Zusammenballungen festgestellt.

Beispiel 3:

Eine Druckplatte vom Typ Enco N-25$^{(R)}$, deren Aluminiumträgermaterial in einer Schleifmittelsuspension mechanisch aufgerauht wurde, und eine Druckplatte vom Typ Enco N-500$^{(R)}$, deren Aluminiumträgermaterial

elektrolytisch aufgerauht wurde, werden in bekannter Weise mittels aktinischer Strahlung bildmäßig belichtet. Die belichteten Platten werden in einem handelsüblichen Entwicklungsgerät mit dem folgenden erfindungsgemäßen Entwicklergemisch entwickelt:

10,50 Gew.-% Benzylalkohol,
6,00 Gew.-% Natriumxylolsulfonat,
23,00 Gew.-% Kaliumtoluolsulfonat und
60,50 Gew.-% Wasser.

Sowohl die Platte vom Typ N-500, als auch die Platte vom Typ N-25 lassen sich rückstandsfrei entwickeln und ergeben Druckformen mit guten Druckeigenschaften. Die Schicht wird beim Entwickeln in Form kleinster Partikel entfernt.

Beispiel 4:

Eine Druckplatte vom Typ Enco N-25(R), deren Aluminiumträgermaterial in einer Schleifmittelsuspension mechanisch aufgerauht wurde, und eine Druckplatte vom Typ Enco N-500(R), deren Aluminiumträgermaterial elektrolytisch aufgerauht wurde, werden in bekannter Weise mittels aktinischer Strahlung belichtet. Die belichteten Platten werden in einem handelsüblichen Entwicklungsgerät mit dem folgenden erfindungsgemäßen Entwicklergemisch entwickelt:

5,50 Gew.-% Benzylalkohol,
6,00 Gew.-% Natriumxylolsulfonat,
23,00 Gew.-% Kaliumtoluolsulfonat und
60,50 Gew.-% Wasser.

Sowohl die Platte vom Typ N-25, als auch die Platte vom Typ N-500 lassen sich einwandfrei, wenn auch nicht ganz leicht entwickeln. Die Schicht wird beim Entwickeln in größeren Fladen entfernt. Der Grund hierfür liegt darin, daß die Komponente a) an der untersten Grenze hinsichtlich der Wirksamkeit des Entwicklers eingesetzt wurde.

Beispiel 5:

Eine Druckplatte vom Typ Enco N-25(R), deren Aluminiumträgermaterial in einer Schleifmittelsuspension mechanisch aufgerauht wurde, und eine Druckplatte vom Typ Enco N-500(R), deren Aluminiumträgermaterial elektrolytisch aufgerauht wurde, werden in bekannter Weise mittels aktinischer Strahlung belichtet. Die belichteten Platten werden in einem handelsüblichen Entwicklungsgerät mit dem folgenden erfindungsgemäßen Entwicklergemisch entwickelt:

25,50 Gew.-% Benzylalkohol,
6,00 Gew.-% Natriumxylolsulfonat,
23,00 Gew.-% Kaliumtoluolsulfonat und
45,50 Gew.-% Wasser.

Sowohl die Platte vom Typ N-25, als auch die Platte vom Typ N-500 lassen sich leicht und einwandfrei

entwickeln.

Beispiel 6:

Eine Druckplatte vom Typ Enco N-25(R), deren Aluminiumträgermaterial in einer Schleifmittelsuspension mechanisch aufgerauht wurde, und eine Druckplatte vom Typ Enco N-500(R), deren Aluminiumträgermaterial elektrolytisch aufgerauht wurde, werden in bekannter Weise mittels aktinischer Strahlung belichtet. Die belichteten Platten werden in einem handelsüblichen Entwicklungsgerät mit dem folgenden erfindungsgemäßen Entwicklergemisch entwickelt:

10,50 Gew.-% Benzylalkohol,
10,00 Gew.-% Natriumxylolsulfonat,
19,00 Gew.-% Kaliumtolulsulfonat,
0,20 Gew.-% Natriumbenzoat,
0,75 Gew.-% TX-100,
0,01 Gew.-% Ionol und
49,44 Gew.-% Wasser.

Sowohl die Platte vom Typ N-25, als auch die Platte vom Typ N-500 lassen sich einwandfrei entwickeln. Die Schicht wird beim Entwickeln in Form kleinster Teilchen entfernt.

Beispiel 7:

Eine Druckplatte vom Typ Enco N-25(R), deren Aluminiumträgermaterial in einer Schleifmittelsuspension mechanisch aufgerauht wurde, und eine Druckplatte vom Typ Enco N-500(R), deren Aluminiumträgermaterial elektrolytisch aufgerauht wurde, werden in bekannter Weise mittels aktinischer Strahlung belichtet. Die belichteten Platten werden in einem handelsüblichen Entwicklungsgerät mit dem folgenden erfindungsgemäßen Entwicklergemisch entwickelt:

10,50 Gew.-% Benzylalkohol,
6,00 Gew.-% Natriumxylolsulfonat,
23,00 Gew.-% Kaliumtolulsulfonat,
0,20 Gew.-% Natriumbenzoat,
0,80 Gew.-% TX-100,
0,01 Gew.-% Ionol und
59,49 Gew.-% Wasser.

Sowohl die Platte vom Typ N-25, als auch die Platte vom Typ N-500 lassen sich rückstandsfrei entwickeln und ergeben Druckformen mit guten Druckeigenschaften. Die Schicht wird beim Entwicklen in Form kleinster Partikel entfernt.

Beispiel 8:

Aus dem folgenden Gemisch wird eine Beschichtungslösung hergestellt:

0,447 g Phosphorsäure (85%-ig),
2,790 g Polyvinylacetat (Mowilith 60, Herst. Hoechst AG),
5,581 g Polystyrol/Maleinsäurehalbester (Sripset 540, Herst. Monsanto),
0,030 g p-Phenylazodiphenylamin,
0,056 g Acetol-Feuerrot 3GLS (der Firma Sandoz) und
5,023 g Diazoniumverbindung gemäß der US-A 3 849 392.

Die genannten Bestandteile werden unter kräftigem Rühren nacheinander in 450 g Ethylenglykolmonomethylether gegeben. Nachdem alle Bestandteile gelöst sind, wird die Lösung abgefiltert und auf eine in einer Schleifmittel-suspension aufgerauhte und hydrophilierte Aluminiumober-fläche aufgetragen. Nach dem Trocknen der Schicht wird durch eine Negativvorlage so belichtet, daß unter einem als Vorlage dienenden 21-Stufen-Staufferkeil eine ausreichende Zahl gehärteter Stufen erhalten wird. Die belichtete Platte wird mit dem wäßrigen Entwickler von Beispiel 7 entwickelt. Die unbelichteten Stellen werden einwandfrei entfernt, während die belichteten Stellen als scharfes Bild erhalten bleiben.

Beispiel 9:

Eine 8" x 25" große Platte der für Druckzwecke geeigneten Aluminiumlegierung 1100 wird mit einer wäßrig-alkalischen Entfettungslösung entfettet und mit einem Wechselstrom von 900 Coulomb in einem Medium aus Salpetersäure und Aluminiumnitrat elektrochemisch aufgerauht. Die aufgerauhte Platte wird gut abgespült und in einem Schwefelsäurebad anodisch oxidiert, wobei das Aluminium als Anode dient. Die Stromstärke und -spannung wird so gewählt, daß eine Oxidschicht von 2,8 g/m$^2$ gebildet wird. Die anodisierte Platte wird gut abgespült und durch Eintauchen in eine Polyvinylphosphonsäurelösung hydrophiliert. Anschließend wird die Platte nochmals gut abgespült und getrocknet. Nun wird sie mit einer Lösung der folgenden Zusammensetzung schleuderbeschichtet:

| | |
|---|---|
| 4,54 Gew-.% | eines Terpolymeren aus Polyvinylacetat, Polyvinylalkohol und Polyvinylformal (Handelsbezeichnung Formvar 12/85), |
| 2,01 Gew.-% | Dipentaerythritmonohydroxypentacrylat, |
| 2,01 Gew.-% | eines diacrylierten Urethanoligomeren, das erhalten wird, indem zunächst 1,6-Hexandiol mit Adipinsäure zu einem Polyester umgesetzt wird, wobei das Molverhältnis von Adipinsäure zu 1,6-Hexandiol größer ist als 1:1, und anschließender erhaltene Polyester mit Dicyclohexylmethan-4,4'-bis-diisocyanat umgesetzt wird, wobei das Molverhältnis von Diisocyanat zu Polyester 2:1 beträgt. Das erhaltene Produkt wird mit 2-Hydroxyethylacrylat umgesetzt, wobei das Molverhältnis von Acrylat zu Reaktionsprodukt aus Diisocyanat und Polyester 2:1 beträgt, |
| 1,22 Gew.-% | des Polykondensationsprodukts aus 3-Methoxy-4-diazo-diphenylaminsulfat und 4,4-Bis-methoxymethyldiphenylether, isoliert als Mesitylensulfonat, |
| 3,20 Gew.-% | 2-Stilbenyl-4,6-di-(trichlormethyl)-triazin und |
| 87,02 Gew.-% | Ethylenglykolmonomethylether. |

Die beschichtete und getrocknete Platte wird durch eine Negativvorlage mittels aktinischer Strahlung so belichtet, daß auf einem 21-Stufen-Staufferkeil eine vollgedeckte Stufe 7 erhalten wird. Die Platte läßt sich mit dem Entwickler von Beispiel 7 mit gutem Ergebnis entwickeln.

Beispiel 10:

Eine 8" x 25" große Platte der für Druckzwecke geeigneten Aluminiumlegierung 1100 wird mit einer wäßrig-alkalischen Entfettungslösung entfettet und mit einem Wechselstrom von 900 Coulomb in einem

Medium aus Salpetersäure und Aluminiumnitrat elektrochemisch aufgerauht. Die aufgerauhte Platte wird gut abgespült und in einem Schwefelsäurebad anodisch oxidiert, wobei das Aluminium als Anode dient. Die Stromstärke und -spannung wird so gewählt, daß eine Oxidschicht von 2,8 g/m² gebildet wird. Die anodisierte Platte wird gut abgespült und durch Eintauchen in eine Polyvinylphosphonsäurelösung hydrophiliert. Anschließend wird die Platte nochmals gut abgespült und getrocknet. Nun wird sie mit einer Lösung der folgenden Zusammensetzung schleuderbeschichtet:

| | |
|---|---|
| 4,54 Gew.-% | eines harzartigen Bindemittels, das erhalten wird, indem man zunächst 75,0 g Vinol 523, ein Polyvinylalkohol/Polyvinylacetat-Copolymeres mit ca. 75 bis 80 Gew.-% Hydroxylgruppen und einem durchschnittlichen Molekulargewicht von etwa 70000, in einer Lösung aus 225 g Wasser und 200 g Ethanol löst und bei einer Temperatur von 70 °C 16 Stunden lang reagieren läßt, anschließend mit 10,13 g Salzsäure (37 %-ig) versetzt, und schließlich unter starkem Rühren 37,66 g Propionaldehyd hinzugibt, wobei die Temperatur auf 60 °C eingestellt ist. Mit Hilfe üblicher Analyseverfahren wird festgestellt, daß das resultierende Produkt 13,6 % Acetat-, 9,8 % Hydroxyl- und 76,7 % Acetalgruppen enthält. 80 % der Acetalgruppen sind sechsgliedrige ringförmige Acetale und 16 % sind intermolekulare Acetale, |
| 2,01 Gew.-% | Dipentaerythritmonohydroxypentacrylat, |
| 2,01 Gew.-% | eines diacrylierten Urethanoligomeren, das erhalten wird, indem zunächst 1,6-Hexandiol mit Adipinsäure zu einem Polyester umgesetzt wird, wobei das Molverhältnis von Adipinsäure zu 1,6Hexandiol größer ist als 1:1, und anschließend der erhaltene Polyester mit Dicyclohexylmethan-4,4'-bis-diisocyanat umgesetzt wird, wobei das Molverhältnis von Diisocyanat zu Polyester 2:1 beträgt. Das erhaltene Produkt wird mit 2-Hydroxyethylacrylat umgesetzt, wobei das Molverhältnis von Acrylat zu Reaktionsprodukt aus Diisocyanat und Polyester 2:1 beträgt, |
| 1,22 Gew.-% | des Polykondensationsproduktes aus 3-Methoxy-4-diazodiphenylaminsulfat und 4,4-Bis-methoxymethyldiphenylether, isoliert als Mesitylensulfonat, |
| 3,20 Gew.-% | 2-Stilbenyl-4,6-di-(trichlormethyl)-triazin und |
| 87,02 Gew.-% | Ethylenglykolmonomethylether |

Die beschichtete und getrocknete Platte wird durch eine Negativbelichtungsvorlage mittels aktinischer Strahlung so belichtet, daß auf einem 21-Stufen-Staufferkeil eine vollgedeckte Stufe 7 erhalten wird. Mit dem Entwickler von Beispiel 7 läßt sich die Platte mit gutem Ergebnis entwickeln.

Beispiel 11:

Eine positiv arbeitende Druckplatte des Typs Enco P7S(R) wird verwendet; diese Druckplatten bestehen aus einem Aluminiumträger, der mit einem lichtempfindlichen Gemisch aus einem Novolakharz und einem Ester von Naphthochinon-(1,2)-diazid-(2)-sulfonsäure-(5) und 1,2,3-Trihydroxybenzophenon als lichtempfindlicher Verbindung beschichtet ist. Die Platte wird durch eine arbeitende Testvorlage in herkömmlicher Weise bildmäßig belichtet. Sie läßt sich mit dem Entickler von Beispiel 7 mit gutem Ergebnis entwickeln.

Beispiel 12:

Eine Druckplatte vom Typs Enco N-25(R), deren Aluminiumträgermaterial in einer Schleifmittelsuspension mechanisch aufgerauht wurde, und eine Druckplatte vom Typ Enco N-500(R), deren Aluminiumträgermaterial elektrolytisch aufgerauht wurde, werden in bekannter Weise mittels aktinischer Strahlung bildmäßig belichtet. Die belichteten Platten werden in einem handelsüblichen Entwicklungsgerät mit dem folgenden erfindungsgemäßen Entwicklergemisch entwickelt:

10,32 Gew.-% Benzylalkohol,
6,00 Gew.-% Natriumcumolsulfonat,
23,00 Gew.-% Kaliumtoluolsulfonat,
0,20 Gew.-% Natriumbenzoat,
0,60 Gew.-% TX-100 und
59,88 Gew.-% Wasser

Beide Druckplatten lassen sich mit gutem Ergebnis entwickeln.

## Ansprüche

1. Wäßriges Entwicklergemisch zum Entfernen der Nichtbildstellen einer auf einem Träger befindlichen lichtempfindlichen Substanz nach deren Belichtung, wobei das Entwicklergemisch organische Lösemittel und Salze enthält, dadurch gekennzeichnet, daß das Gemisch
   a) 5 bis 30 Gew.-% Benzylalkohol,
   b) 1 bis 20 Gew.-% eines Alkali-, bevorzugt Natrium-, -xylolsulfonates und/oder Alkali-, bevorzugt Natrium-, -cumolsulfonates,
   c) 5 bis 40 Gew.-% eines Alkali-, bevorzugt Kalium-, -toluolsulfonates, und
   d) ergänzt zu 100 Gew.-% Wasser enthält.

2. Entwicklergemisch nach Anspruch 1, dadurch gekennzeichnet, daß es 8 bis 25 Gew.-% der Komponente a) enthält.

3. Entwicklergemisch nach einem der Ansprüche 1 oder 2, dadurch gekennzeichnet, daß es 3 bis 15 Gew.-% der Komponente b) enthält.

4. Entwicklergemisch nach einem der Ansprüche 1 bis 3, dadurch gekennzeichnet, daß es 15 bis 35 Gew.-% der Komponente b) enthält.

5. Entwicklergemisch nach einem der Ansprüche 1 bis 4, dadurch gekennzeichnet, daß es zusätzlich weitere Salze und/oder Antioxidantien und/oder Netzmittel und/oder Antischaummittel enthält.

6. Entwicklergemisch nach einem der Ansprüche 1 bis 5, dadurch gekennzeichnet, daß es als weitere Salze wenigstens ein Salz aus der Gruppe Alkaliphosphate, -nitrate, -chloride, -borate, -acetate, -sulfate, -citrate, -sulfite, -tartrate, -oxalate, -formiate, -propionate, -succinate, -glutamate und -benzoate enthält.

7. Entwicklergemisch nach Anspruch 6, dadurch gekennzeichnet, daß es das Salz oder die Salze in einer Menge von 0,1 bis 10 Gew.-%, jeweils bezogen auf das Gewicht des Entwicklers, enthält.

8. Entwicklergemisch nach einem der Ansprüche 5 bis 7, dadurch gekennzeichnet, daß es das Antioxidans in einer Menge von 0,005 bis 0,2 Gew.-%, bezogen auf das Gesamtgewicht des Entwicklers, enthält.

9. Entwicklergemisch nach einem der Ansprüche 5 bis 8, dadurch gekennzeichnet, daß es das oder die Netzmittel in einer Menge von 0,1 bis 2 Gew.-%, bezogen auf das Gesamtgewicht des Entwicklers, enthält.

10. Entwicklergemisch nach einem der Ansprüche 5 bis 9, dadurch gekennzeichnet, daß es ein Netzmittel der allgemeinen Formel

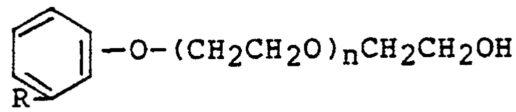

enthält, wobei in der Formel

n = 4 - 40 und
R = H = OH
= $C_8H_{17}$
= $C_9H_{19}$
= $C_{10}H_{21}$ oder
= $CH_3(CH_2)_m$-O-$(CH_2CH_2O)_{n'}CH_2CH_2OH$
bedeuten und wobei
m = 9 - 30
n '= 4 - 20 ist.

**11.** Entwicklergemisch nach einem der Ansprüche 1 bis 10, dadurch gekennzeichnet, daß es einen Flammpunkt von über 93 °C (200 °F) aufweist.

**12.** Verfahren zum Entwickeln eines lithographischen Druckmaterials, das aus einem Träger besteht, der mit einer lichtempfindlichen Schicht versehen ist nach deren Belichtung, dadurch gekennzeichnet, daß man mit einem Entwicklergemisch entwickelt, das aus
a) 5 bis 30 Gew.-% Benzylalkohol,
b) 1 bis 20 Gew.-% eines Alkali-, bevorzugt Natrium-, -xylolsulfonates und/oder Alkali-, bevorzugt Natrium-, -cumolsulfonates,
c) 5 bis 40 Gew.-% eines Alkali-, bevorzugt Kalium-, -toluolsulfonates, und
d) ergänzt zu 100 Gew.-% Wasser besteht.

**13.** Verfahren nach Anspruch 12, dadurch gekennzeichnet, daß man ein lithographisches Druckmaterial entwickelt, dessen Träger aus Aluminium besteht.

**14.** Verfahren nach Anspruch 13, dadurch gekennzeichnet, daß man ein lithographisches Druckmaterial entwickelt, dessen Aluminiumträger mechanisch und/oder chemisch und/oder elektrochemisch aufgerauht wird.

**15.** Verfahren nach einem der Ansprüche 12 bis 14, dadurch gekennzeichnet, daß man ein lithographisches Druckmaterial entwickelt, dessen Aluminiumträger anodisiert wird.

**16.** Verfahren nach einem der Ansprüche 12 bis 15, dadurch gekennzeichnet, daß man ein lithographisches Druckmaterial entwickelt, dessen Aluminiumträger hydrophiliert wird.

**17.** Verfahren nach einem der Ansprüche 12 bis 16, dadurch gekennzeichnet, daß man ein lithographisches Druckmaterial entwickelt, das als lichtempfindliche Schicht ein Diazoniumsalz, ein Chinondiazid oder ein ein Photopolymeres enthaltendes Gemisch enthält.

**18.** Verfahren nach einem der Ansprüche 12 bis 17, dadurch gekennzeichnet, daß man ein lithographisches Druckmaterial entwickelt, das in der lichtempfindlichen Schicht ein Harz enthält.

**19.** Verfahren nach nach Anspruch 17 oder 18, dadurch gekennzeichnet, daß man ein lithographisches Druckmaterial entwickelt, das als lichtempfindliche Schicht ein Diazoniumsalz der allgemeinen Formel
$A\text{-}N_2^+X^-$
enthält, wobei A ein aromatischer oder heterozyklischer Rest und X das Anion einer Säure ist.

**20.** Verfahren nach einem der Ansprüche 12 bis 19, dadurch gekennzeichnet, daß man innerhalb von 2 Minuten entwickelt.

**Claims**

**1.** Aqueous developer mixture for removing the non-image areas of a photosensitive substance located on a carrier after it has been exposed, the developer mixture containing organic solvents and salts, characterized in that the mixture contains

a) 5 to 30% by weight of benzyl alcohol,
b) 1 to 20% by weight of an alkali-metal xylenesulphonate, preferably sodium xylenesulphonate, and/or alkali-metal cumenesulphonate, preferably sodium cumenesulphonate,
c) 5 to 40% by weight of an alkali-metal toluenesulphonate, preferably potassium toluenesulphonate, and
d) is made up to 100% by weight with water.

**2.** Developer mixture according to Claim 1, characterised in that it contains 8 to 25% by weight of the component a).

**3.** Developer mixture according to either of Claims 1 or 2, characterised in that it contains 3 to 15% by weight of the component b).

**4.** Developer mixture according to any of Claims 1 to 3, characterised in that it contains 15 to 35% by weight of the component b).

**5.** Developer mixture according to any of Claims 1 to 4, characterised in that it additionally contains further salts and/or antioxidants and/or wetting agents and/or anti-foaming agents.

**6.** Developer mixture according to any of Claims 1 to 5, characterised in that it contains, as further salts, at least one salt from the group comprising alkali-metal phosphates, nitrates, chlorides, borates, acetates, zulphatez, citrates, sulphitez, tartratez, oxalates, formates, propionates, zuccinates, glutamates and benzoatez.

**7.** Developer mixture according to Claim 6, characterised in that it contains the salt or the salts in an amount of 0.1 to 10% by weight, based in all cases on the weight of the developer.

**8.** Developer mixture according to any of Claims 5 to 7, characterised in that it contains the antioxidant in an amount of 0.005 to 0.2% by weight, based on the total weight of the developer.

**9.** Developer mixture according to any of Claims 5 to 8, characterised in that it contains the wetting agent or the wetting agents in an amount of 0.1 to 2% by weight, based on the total weight of the developer.

**10.** Developer mixture according to any of Claims 5 to 9, characterised in that it contains a wetting agent of the general formula

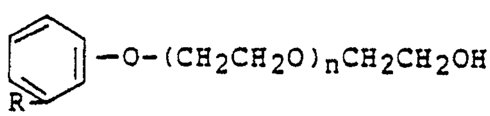

where, in the formula
n = 4 - 40 and
R = H
= OH
= $C_8H_{17}$
= $C_9H_{19}$
= $C_{10}H_{21}$ or
= $CH_3(CH_2)_m$-O- $(CH_2CH_2O)_{n'}CH_2CH_2OH$
and where
m = 9 - 30
n' = 4 - 20.

**11.** Developer mixture according to any of Claims 1 to 10, characterised in that it has a flash point of over

93 °C (200 °F).

**12.** Process for developing a lithographic printing material which is composed of a carrier which is provided with a photosensitive layer, after the latter has been exposed, characterised in that development is carried out with a developer mixture which is composed of
a) 5 to 30% by weight of benzyl alcohol,
b) 1 to 20% by weight of an alkali-metal xylenesulphonate, preferably sodium xylenesulphonate, and/or alkali-metal cumenezulphonate, preferably sodium cumenesulphonate,
c) 5 to 40% by weight of an alkali-metal toluenesulphonate, preferably potassium toluenezulphonate, and
d) is made up to 100% by weight with water.

**13.** Process according to Claim 12, characterised in that a lithographic printing material is developed whose carrier is composed of aluminium.

**14.** Process according to Claim 13, characterised in that a lithographic printing material is developed whose aluminium carrier is mechanically and/or chemically and/or electrochemically roughened.

**15.** Process according to any of Claims 12 to 14, characterised in that a lithographic printing material is developed whose aluminium carrier is anodised.

**16.** Process according to any of Claims 12 to 15, characterised in that a lithographic printing material is developed whose aluminium carrier is hydrophilised.

**17.** Process according to any of Claims 12 to 16, characterised in that a lithographic printing material is developed which contains a diazonium salt, a quinone diazide or a mixture containing a photopolymer as photosensitive layer.

**18.** Process according to any of Claims 12 to 17, characterised in that a lithographic printing material is developed which contains a resin in the photosensitive layer.

**19.** Process according to Claim 17 or 18, characterised in that a lithographic printing material is developed which contains, as photosensitive layer, a diazonium salt of the general formula

$$A{-}N_2^+X^-$$

where A is an aromatic or heterocyclic radical and X is the anion of an acid.

**20.** Process according to any of Claims 12 to 19, characterised in that development is carried out within 2 minutes.

## Revendications

**1.** Mélange développataur aqueux pour l'élimination, des zones de non-image, d'une substance photosensib1e se trouvant sur un support, après son exposition le mélange développateur renfermant des solvants et des sels organiques, caractérisé en ce que le mélange contient
a) 5 à 30% en poids d'alcool benzylique,
b) 1 à 20% en poids d'un xylènesulfonate alcalin, de préférence de sodium, et/ou d'un cumènesulfonate alcalin, de préférence de sodium,
c) 5 à 40% en poids d'un toluénesulfonate alcalin, de préférence d potassium, et
d) de l'eau à concurrence de 100% en poids.

**2.** Mélange développteur selon la revendication 1, caractérisé en ce qu'il contient 8 à 25% en poids du composant a).

**3.** Mélange développateur selon une des revendications 1 ou 2, caractérisé en ce qu'il contient 3 à 15%

en poids du composant b).

4. Mélange développateur selon une des revendictions 1 à 3, caractérisé en ce qu'il contient 15 à 35%. en poids du composant b).

5. Mélange développateur selon une das revendiction 1 à 4, caractérisé en ce qu'il contient en outre d'autres sels et/ou antioxydants et/ou mouillants et/ou agents antimousse.

6. Mélange développateur selon une des revendications 1 à 5, caractérisé en ce qu'il contient en outre, comme autres sels, au moins un sel choisi parmi les phosphates, les nitrates, les chlorures les borates,les acétates , les sulfates, les citrates les sulfites, les tartrates, les oxalates, les formiates, les propionates, les succinates, les glutamates et les benzoates alcalins.

7. Mélange développateur selon la revendication 6, caractérisé en ce qu'il contient le sel ou les sels à raison de 0,1 à 10% en poids, chaque fois par rapport au poids total du développateur.

8. Mélange développateur selon une des revendications 5 à 7, caractérisé en ce qu'il contient l'antioxydant à raison de 0,005 à 0,2% en poids, par rapport au poids total du développateur.

9. Mélange déleloppateur selon une des revendications 5 à 8, caractérisé en ce qu'il contient le ou les mouillant(s) à raison de 0,1 à 2% en poids, par rapport au poids total du développateur.

10. Mélange développateur selon une des revendications 5 à 9, caractérisé en ce qu'il contient un mouillant de formule générale

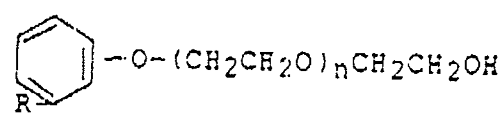

dans laquelle n vaut 4 à 40 et R représente H, OH, $C_8H_{17}$, $C_9H_{19}$, $C_{10}H_{21}$ ou $CH_3(CH_2)_m$-O-$(CH_2CH_2O)_{n'}CH_2CH_2OH$, avec m = 9 à 30 et n' = 4 à 20.

11. Mélange développateur selon une des revendications 1 à 10, caractérisé en ce qu'il présente un point de flamme supérieur à 93 °C (200 °F).

12. Procédé pour développer, aprés son exposition, un matériel d'impression lithographique, qui se compose d'un support pourvu d'une couche photosensible, caractérisé en ce que l'on effectue le développement à l'aide d'un mélange développateur, qui contient:
   a) 5 à 30% en poids d'alcool benzylique,
   b) 1 à 20% en poids d'un xylènesulfonate alcalin, de préférence de sodium, et/ou d'un cumènesulfonate alcalin, de préférence de sodium,
   c) 5 à 40% en poids d'un toluènesulfonate alcalin, de préférence de potassium, et
   d) de l'eau à concurrence de 100% en poids.

13. Procédé selon la revendication 12, caractérisé en ce l'on développe un matériel d'impression lithographique dont le support est en aluminium.

14. Procédé selon la revendication 13, caractérisé en ce l'on développe un matériel d'impression lithographique, dont le support en aluminium est grainé mécaniquement et/ou chimiquement et/oU électrochimiquement.

15. Procédé selon une des revendications 12 à 14, caractérisé en ce l'on développe un matériel d'impression lithographique, dont le support en aluminium est oxydé anodiquement.

16. Procédé selon une des revendications 12 à 15, caractérisé on ce l'on développe un matériel d'impression lithographique, dont le support en aluminium est hydrophilisé.

17. Procédé selon une des revendications 12 à 16, caractérisé en ce l'on dèveloppe un matériel

d'impression lithographique, qui contient, comme couche photosensible, un sel de diazonium, un quinonediazide ou un mélange renfermant un photopolymère.

**18.** Procédé selon une des revendications 12 à 17, caractérisé en ce l'on développe un matériel d'impression lithographique, qui contient une résine dans la couche photosensible.

**19.** Procédé selon une des revendications 17 ou 18, caractérisé en ce l'on développe un matériel d'impression lithographique, qui contient, comme couche photosensible, un sel de diazonium de formule générale
$A\text{-}N_2^+X^-$,
dans laquelle A est un reste aromatique ou hétérocyclique et X est l'anion d'un acide.

**20.** Procédé selon une des revendications 12 à 19, caractérisé en ce l'on effectue le développement en 2 minutes.